# EUROPEAN PATENT SPECIFICATION

(11) **EP 4 006 966 B1**
(45) Date of publication and mention of the grant of the patent: **04.09.2024**
(21) Application number: 20848291.9
(22) Date of filing: 29.07.2020
(51) Int. Cl.: H01L 23/12, H05K 1/02, H05K 3/00, H01L 23/544, H01L 23/373, H01L 23/15

(54) **COMPOSITE SUBSTRATE AND METHOD FOR MANUFACTURING SAME, AND CIRCUIT SUBSTRATE AND METHOD FOR MANUFACTURING SAME**
VERBUNDSUBSTRAT UND VERFAHREN ZU SEINER HERSTELLUNG SOWIE SCHALTUNGSSUBSTRAT UND VERFAHREN ZU SEINER HERSTELLUNG
SUBSTRAT COMPOSITE ET SON PROCÉDÉ DE FABRICATION, ET SUBSTRAT DE CIRCUIT ET SON PROCÉDÉ DE FABRICATION

(30) Priority: 31.07.2019 JP 2019141146
(43) Date of publication of application: 01.06.2022
(73) Proprietor: Denka Company Limited, Tokyo 103-8338 (JP)
(72) Inventor: YUASA, Akimasa, Tokyo 103-8338 (JP); KOBASHI, Seiji, Tokyo 103-8338 (JP); NISHIMURA, Koji, Tokyo 103-8338 (JP)
(74) Representative: Gulde & Partner
(86) International application number: PCT/JP2020/029146
(87) International publication number: WO 2021/020471

(56) References cited:
- WO-A1-2013/058287
- WO-A1-2019/003880
- JP-A- 2002 178 325
- JP-A- 2005 294 668
- JP-A- 2009 252 971
- JP-A- 2009 252 971
- JP-A- 2010 050 164
- JP-A- 2010 050 164
- JP-A- 2011 029 279
- JP-A- 2013 102 033
- JP-A- 2013 201 221
- JP-A- 2013 201 221
- US-A1- 2020 146 144

## Description

### Technical Field

The present disclosure relates to a composite substrate and a method for manufacturing the same, and a circuit substrate manufacturing method.

### Background Art

An insulating ceramic substrate may be used as a circuit substrate mounted on an electronic device. The following techniques as described in Patent Literature 1 are known as a method for manufacturing such a circuit substrate. In other words, a composite substrate is formed by joining metal layers to both surfaces of a ceramic substrate having a scribe line formed on its surface. Then, the metal layer on the surface of the composite substrate is processed into a circuit pattern by etching. Subsequently, the composite substrate is divided along the scribe line and a plurality of circuit substrates are manufactured.

Meanwhile, mark formation techniques are known so that a worker and an automatic assembly machine recognize product information in manufacturing a circuit substrate and a package including the circuit substrate. For example, Patent Literature 2 proposes a technique with which a specific part of a sintered body of ceramics is given a color tone different from that of another part to serve as a marking portion. Patent Literature 3 proposes using a barcode-shaped marker pattern.

Further ceramic substrates to be used as circuit boards for electronic devices are described in Patent Literatures 4 to 8.

### Citation List

### Patent Literature

Patent Literature 1: JP 2007-324301 A
Patent Literature 2: JP 2001-97786 A
Patent Literature 3: EP 3361504 A
Patent Literature 4: JP 2013-01221 A
Patent Literature 5: WO 2013/058287 A
Patent Literature 6: JP 2010-050164 A
Patent Literature 7: JP 2009-252971 A
Patent Literature 8: WO 2019/003880 A1

### Summary of Invention

### Technical Problem

After a circuit or the like is formed, a ceramic substrate is processed by cutting or the like to become a product or a component. With electronic devices further improving in terms of performance, it is required to sufficiently enhance the processing accuracy at the time of such circuit formation and processing. For the processing accuracy enhancement, the ceramic substrate needs to be aligned with high accuracy in each process. However, the barcode-shaped marker pattern or the like is usually different for each sheet and cannot be easily used for alignment.

In this regard, the present invention provides a composite substrate according to claim 1, capable of enhancing alignment accuracy and a method for manufacturing the same, according to claim 5. In addition, the present disclosure provides a composite substrate in which the positional accuracy of metal and ceramic substrates is excellent and a method for manufacturing the same. In addition, the present disclosure provides a circuit substrate excellent in alignment accuracy when a divided substrate is obtained by division and a method for manufacturing the same.

### Solution to Problem

A composite substrate according to one aspect of the present invention comprises a ceramic substrate and a metal sheet, wherein the metal sheet is joined to the ceramic substrate so as to cover the main surface; wherein the ceramic substrate includes a main surface having a plurality of sections divided by division lines in the form of scribe lines and an alignment mark; wherein the main surface has at least one of the scribe lines closer to a center of the main surface than the alignment mark; and wherein the alignment mark is provided in an end portion delimited by an outer edge of the main surface and the scribe line that is positioned farthest from the center of the main surface; wherein the metal sheet has at least one selected from a group consisting of a notch portion and a through hole; and wherein the alignment mark is exposed from the notch portion or the through hole.

Such a composite substrate has the alignment mark on the main surface, and thus the alignment accuracy in using the composite substrate can be improved. Further, the main surface has at least one of the scribe lines closer to the center than the alignment mark, and thus the part closer to the center than the alignment mark can be effectively used for various components and products. It should be noted that the "scribe line closer to the center than the alignment mark" in the present disclosure means a scribe line intersecting with the line segment connecting the alignment mark and the center of the surface of the ceramic substrate.

The alignment mark may have at least one selected from a group consisting of an intersection and a rotationally symmetric shape. The alignment accuracy can be further improved with the alignment mark having such a shape.

In the composite substrate, an identification mark different in shape from the alignment mark may be provided on the main surface and at least one of the scribe lines may be provided closer to the center of the main surface than the identification mark. By having the identification mark, traceability can be improved and quality management can be performed efficiently. Further, the scribe line is provided closer to the center than the identification mark, and thus the part closer to the center than the identification mark can be effectively used for various components and products. It should be noted that the "scribe line closer to the center than the identification mark" in the present disclosure means a scribe line intersecting with the line segment connecting the identification mark and the center of the surface of the ceramic substrate.

In the composite substrate, the alignment mark may be two or more in number. In this manner, the alignment accuracy can be improved even in a case where a plurality of ceramic substrates having different sizes or shapes are aligned.

The alignment mark is provided in an end portion divided by an outer edge of the main surface and the scribe line. In this manner, the part of the composite substrate that cannot be effectively used as a product or a component can be reduced and the manufacturing costs of the composite substrate and a component and a product using the ceramic substrate can be reduced.

The composite substrate according to the present invention includes: the ceramic substrate as described above; and a metal sheet joined to the ceramic substrate so as to cover the main surface. Thus, alignment during joining can be performed with high accuracy. Accordingly, the positional accuracy of the metal and ceramic substrates is excellent.

The metal sheet has at least one selected from a group consisting of a notch portion and a through hole, and the alignment mark is exposed from the notch portion or the through hole. In this manner, the accuracy of alignment can be improved during, for example, metal sheet joining, resist application, and circuit formation.

A circuit substrate using the composite substrate according to the present invention includes: the ceramic substrate as described above; and a conductor portion provided on the main surface so as to be independent for each section defined by the scribe lines, in which the alignment mark is exposed on the main surface. By having such an alignment mark, the alignment accuracy at a time when, for example, a divided substrate is obtained by division can be improved.

A composite substrate manufacturing method according to another aspect of the present invention includes: a step of obtaining a ceramic base material having an alignment mark on a main surface; a step of obtaining a ceramic substrate by irradiating the main surface with laser light to form scribe lines dividing the main surface into a plurality of sections; and a step of obtaining the composite substrate by joining a metal sheet to the ceramic substrate so as to cover the main surface of the ceramic substrate. The main surface of the ceramic substrate has at least one of the scribe lines closer to a center of the main surface than the alignment mark. The alignment mark is provided in an end portion delimited by an outer edge of the main surface and the scribe line that is positioned farthest from the center of the main surface, and the metal sheet is joined in the step of obtaining the composite substrate such that the alignment mark is exposed from at least one selected from a group consisting of a notch portion and a through hole of the metal sheet.

In this manufacturing method, the ceramic base material having the alignment mark on the main surface is used, and thus the alignment accuracy in forming the scribe lines can be improved. In addition, the ceramic substrate has the alignment mark on the main surface, and thus the alignment accuracy in using the ceramic substrate can be improved. In addition, the ceramic substrate where the scribe lines are formed has at least one of the scribe lines closer to the center than the alignment mark, and thus the part closer to the center than the alignment mark can be effectively used for various components and products.

In this manufacturing method, the ceramic substrate having the alignment mark is used, and thus the alignment accuracy of the ceramic and metal sheets can be enhanced. Accordingly, a composite substrate in which the positional accuracy of ceramic and metal sheets is excellent can be manufactured.

The metal sheet is joined in the step of obtaining the composite substrate such that the alignment mark is exposed from at least one selected from a group consisting of a notch portion and a through hole of the metal sheet. By using the alignment mark exposed from the notch portion or the through hole, the accuracy of alignment can be improved during, for example, metal sheet joining, resist application to the metal sheet, and circuit formation.

A circuit substrate manufacturing method according to one aspect of the present disclosure includes a step of obtaining a circuit substrate where the alignment mark on the main surface of the ceramic substrate is exposed by removing a part of the metal sheet in the composite substrate obtained by the manufacturing method and forming an independent conductor portion for each section defined by the scribe lines. The alignment mark is exposed on the main surface of the ceramic substrate in the circuit substrate obtained by this manufacturing method. Accordingly, the alignment accuracy at a time when, for example, a divided substrate is obtained by division can be improved.

### Advantageous Effects of Invention

According to the present disclosure, a composite substrate capable of enhancing alignment accuracy and a method for manufacturing the same are provided. In addition, the present disclosure is capable of providing a composite substrate in which the positional accuracy of metal and ceramic substrates is excellent and a method for manufacturing the same. In addition, the present disclosure is capable of providing a circuit substrate excellent in alignment accuracy when a divided substrate is obtained by division and a method for manufacturing the same.

### Brief Description of Drawings

FIG 1 is a perspective view of a ceramic substrate to be used in the composite substrate according to an embodiment.
FIG 2 is a partially enlarged view illustrating a part of the ceramic substrate of FIG 1.
FIG 3 is a plan view of a ceramic substrate to be used in the composite substrate according to another embodiment.
FIG 4 is a plan view of a ceramic substrate to be used in the composite substrate according to yet another embodiment.
FIG 5 is a perspective view of a composite substrate
FIG 6 is a perspective view of a composite substrate according to an embodiment.
FIG 7 is a perspective view of a circuit substrate according to a further embodiment, manufactured by further processing the composite substrate of the embodiment in Fig. 6.
FIG 8 is a plan view illustrating an example of a ceramic base material.
FIG 9 is a perspective view illustrating an example of a ceramic substrate to which a brazing material is applied.
FIG 10 is a perspective view illustrating an example of a composite substrate having a resist pattern formed on a main surface.

### Description of Embodiments

Hereinafter, an embodiment of the present disclosure will be described with reference to the drawings as the case may be. However, the following embodiment is an example for describing the present disclosure and is not intended to limit the present disclosure to the following content. In the description, the same reference numerals are used for the same elements or elements identical in terms of function with redundant description omitted as the case may be. In addition, the positional relationships including up, down, left, and right are based on those illustrated in the drawings unless otherwise noted. Further, the dimensional ratio of each element is not limited to the illustrated ratio.

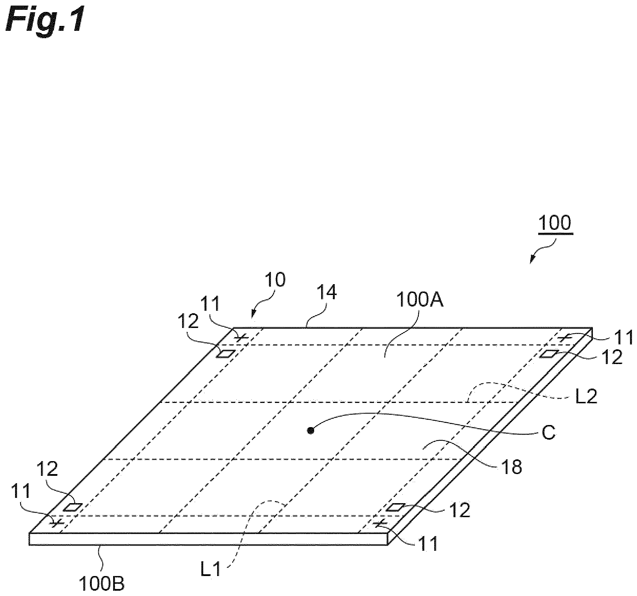

FIG 1 is a perspective view of a ceramic substrate to be used in a composite substrate according to an embodiment of the present invention. A ceramic substrate 100 of FIG 1 has a flat plate shape. A main surface 100A (front surface 101A) of the ceramic substrate 100 is divided into a plurality of sections by scribe lines. The main surface 100A is provided with a plurality of scribe lines L1 and a plurality of scribe lines L2 as the scribe lines. The plurality of scribe lines L1 extend along a first direction and are arranged at equal intervals. The plurality of scribe lines L2 extend along a second direction orthogonal to the first direction and are arranged at equal intervals. The scribe line L1 and the scribe line L2 are orthogonal to each other.

The scribe lines L1 and L2 may, for example, be configured by arranging a plurality of recesses in a straight line or have grooves formed in a linear shape. Specifically, the scribe lines L1 and L2 may be formed by laser light. Examples of a laser source include a carbonic acid gas laser and a YAG laser. The scribe line can be formed by intermittently emitting laser light from such a laser source. It should be noted that the scribe lines L1 and L2 may not be arranged at equal intervals and are not limited to those orthogonal to each other. In addition, the scribe lines L1 and L2 may be curved or bent without being straight.

The ceramic substrate 100 has a plurality of sections 18 defined by the scribe lines L1 and L2. The ceramic substrate 100 has alignment marks 11 and identification marks 12 in an end portion 10 of the main surface 100A. The end portion 10 is an outer peripheral region divided by an outer edge 14 of the main surface 100A and one or both of the scribe line L1 and the scribe line L2 positioned farthest from a center C of the main surface 100A. In a case where the ceramic substrate 100 is for a circuit substrate, the region that surrounds the plurality of sections 18 where conductor portions are formed corresponds to the end portion 10.

The main surface 100A has at least one scribe line L1 and at least one scribe line L2 closer to the center C than the alignment mark 11 and the identification mark 12. In other words, the main surface 100A has the scribe lines L1 and L2 intersecting with respective line segments connecting the center C to the alignment marks 11 and the identification marks 12. By cutting along the scribe lines L1 and L2, the part that is closer to the center C than the alignment marks 11 and the identification marks 12 can be effectively used for various components and products. The main surface 100A has at least one section 18 including the center C.

At the four corners of the main surface 100A of the ceramic substrate 100, the four alignment marks 11 and the four identification marks 12 are provided so as to be adjacent to each other. By having the plurality of alignment marks in this manner, the accuracy of alignment can be further enhanced.

A main surface 100B (back surface 100B) of the ceramic substrate 100 may also have the scribe lines L1 and L2, the alignment marks 11, and the identification marks 12 as in the case of the main surface 100A. However, it is not essential for the main surface 100B to have all of these. For example, the main surface 100B may have at least one of the scribe lines L1 and L2, the alignment marks 11, and the identification marks 12 or may not have any of the scribe lines L1 and L2, the alignment marks 11, and the identification marks 12.

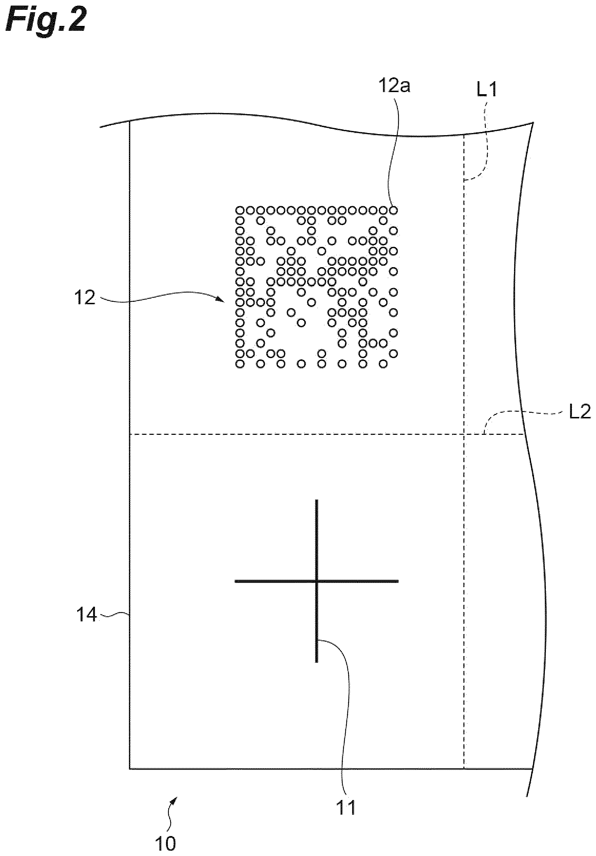

FIG 2 is a partially enlarged view illustrating the part where one of the four alignment marks 11 in the end portion 10 of the main surface 100A of the ceramic substrate 100 and one of the four identification marks 12 in the end portion 10 of the main surface 100A of the ceramic substrate 100 are provided.

The alignment mark 11 has a cross shape in a plan view. The alignment mark 11 is configured to be detectable by, for example, an imaging device (e.g. camera or video). The alignment mark 11 has an intersection where two or more line segments intersect, and thus the reference for alignment becomes clear and the accuracy of alignment can be further enhanced. From a similar viewpoint, the alignment mark 11 may have a rotationally symmetric shape in a plan view. In a case where the alignment mark 11 has a rotationally symmetric shape, the accuracy of alignment can be further enhanced by the center of rotation serving as a reference for alignment. In a plan view, the alignment mark 11 may be, for example, circular, triangular, or quadrangular.

In a case where the alignment mark 11 is circular, the diameter of the alignment mark 11 may be 50 to 450 µm. In a case where the alignment mark 11 has a polygonal outer shape, the diameter at a time when the circumscribed circle is drawn may be 50 to 450 µm. With the alignment mark 11 having such a size, the effectively usable part of the ceramic substrate 100 can be made sufficiently large and the accuracy of imaging device-based detection can be sufficiently enhanced. In a case where the alignment mark 11 is configured by a recessed portion having a depth (such as a groove and a hole), the depth may be 10 to 50 µm. However, it is not essential for the alignment mark 11 to have a depth and the alignment mark 11 may be a two-dimensional pattern.

The identification mark 12 is a two-dimensional code and is configured by a plurality of recessed portions 12a being arranged in accordance with a predetermined rule. The identification mark 12 may be, for example, a two-dimensional barcode such as a QR code (registered trademark) or may be a one-dimensional code such as a barcode. In addition, the identification mark 12 may be a three-dimensional code using, for example, information on the depth of the recessed portion 12a as well. In addition, the identification mark 12 is not limited to that configured by the recessed portion 12a. For example, the identification mark 12 may be configured by a two-dimensional pattern or may be a combination of the recessed portion 12a and a pattern.

The identification mark 12 is provided for the ceramic substrate 100 to be identified. The identification mark 12 may be a code associated with some information. Examples of the information include information on lots, manufacturing histories, product types, uses, qualities, and manufacturing conditions. By using the identification mark 12, manufacturing conditions can be optimized and improvements can be achieved in terms of quality, the accuracy of process management, traceability, and so on.

The identification mark 12 may be, for example, at least one of the following information (a) to (d) that has been coded.
(a) Information on a raw material at a time of manufacturing a green sheet for a ceramic substrate
(b) Information on molding conditions for the green sheet
(c) Information on a mold release agent used when the green sheet is laminated
(d) Serial number of the green sheet or the ceramic substrate

The identification mark 12 is also configured to be detectable by, for example, an imaging device (e.g. camera or video). The imaging device may have, for example, an information processing unit collating a captured image with pre-recorded information and outputting information based on the collation result.

The depth of the recessed portion 12a constituting the identification mark 12 may be 10 to 100 µm or 12 to 80 µm. As for the size of the identification mark 12, the length of each side may be approximately 1 to 5 mm in a plan view. With the identification mark 12 having such a size, the effectively usable part of the ceramic substrate 100 can be made sufficiently large and the accuracy of imaging device-based detection can be sufficiently enhanced.

The positions and numbers of the alignment marks 11 and the identification marks 12 are not limited to those described above. The alignment mark 11 and the identification mark 12 may be provided so as to be adjacent to each other in the end portion 10 as in the presently discussed ceramic substrate or may be provided apart from each other. In addition, the numbers of the alignment marks 11 and the identification marks 12 may be different from each other without being equal to each other.

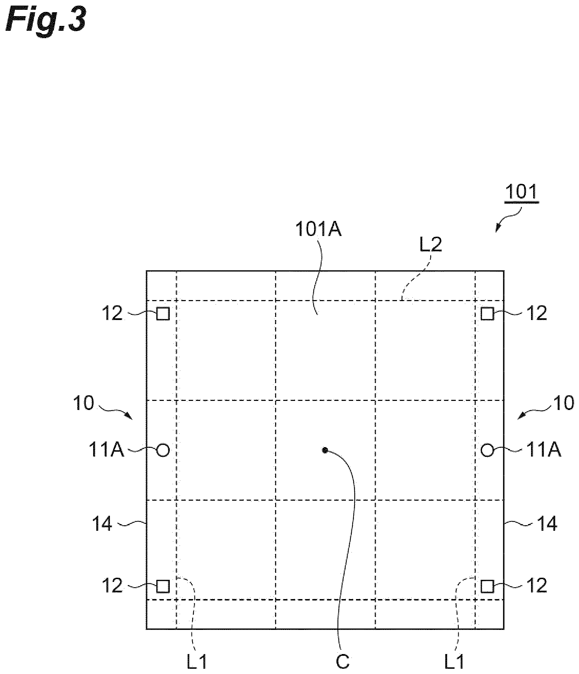

FIG 3 is a plan view of a ceramic substrate to be used in the composite substrate according to another embodiment. A ceramic substrate 101 of FIG 3 is different from the ceramic substrate 100 illustrated in FIGS. 1 and 2 in the number, positions, and shape of alignment marks. The ceramic substrate 101 is provided with two circular alignment marks 11A in the end portions 10 of the main surface 101A. The two alignment marks 11A are respectively provided near the middle in the up-down direction of FIG 3 in the left and right end portions 10 of FIG 3. The configuration of the ceramic substrate 101 other than the alignment mark 11A may be identical to that of the ceramic substrate 100.

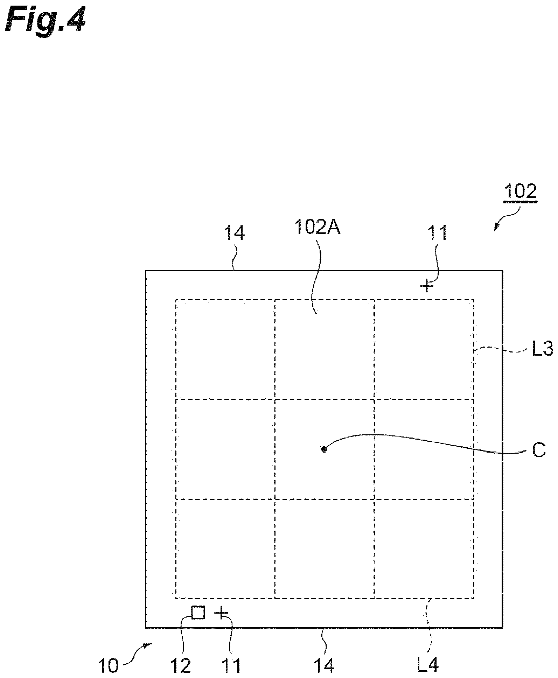

FIG 4 is a plan view of a ceramic substrate to be used in the composite substrate according to yet another embodiment. A ceramic substrate 102 of FIG 4 is different from the ceramic substrate 100 illustrated in FIGS. 1 and 2 in the numbers and positions of alignment and identification marks. In addition, the ceramic substrate 102 of FIG 4 is different from the ceramic substrate 100 illustrated in FIGS. 1 and 2 in that scribe lines L3 and L4 do not extend to the outer edge of a main surface 102A. In the end portion 10 of the main surface 102A of the ceramic substrate 102, the alignment marks 11 are respectively provided near two corner portions diagonal to each other. In addition, one identification mark 12 is provided near one of the alignment marks 11.

The ceramic substrates 100, 101, and 102 have the alignment marks 11 and 11A on the main surfaces 100A, 101A, and 102A, and thus the alignment accuracy in processing the ceramic substrates 100, 101, and 102 can be improved. As a result, defective product generation can be suppressed and damage to the identification mark 12 during laser processing can be suppressed. The alignment marks 11 and 11A and the identification mark 12 are provided in the end portion 10, and thus the part inside the end portion 10 can be used for various components and products. In this manner, most of the ceramic substrates 100, 101, and 102 can be effectively used and the manufacturing costs of products and components using the ceramic substrates 100, 101, and 102 can be reduced. In addition, the ceramic substrates 100, 101, and 102 have the identification mark 12 in the end portion 10, and thus traceability can be improved and quality management can be efficiently performed.

The ceramic substrate of the present disclosure is not limited to the ceramic substrates 100, 101, and 102 described above. For example, the alignment mark does not have to be two or more in number and may be one in number. However, the accuracy of alignment can be sufficiently enhanced by having two or more alignment marks. In addition, the accuracy of alignment can be further enhanced by two or more alignment marks being provided apart from each other in the end portion of the main surface. In a case where the main surface has, for example, a rectangular outer shape, the alignment marks may be provided in two corner portions diagonal to each other or may be provided in the four corner portions.

Each of the ceramic substrates described above has the alignment mark 11 (11A) and the identification mark 12 in the end portion 10 divided by the outer edge 14 of the main surface and at least one of the scribe line L1 and the scribe line L2. However, the present disclosure is not limited thereto and the alignment mark or the identification mark may be provided at a position other than the end portion 10. In addition, the ceramic substrate may lack the identification mark. The ceramic substrate can be effectively used while enhancing the accuracy of alignment insofar as a section (scribe line) is provided closer to the center C than the alignment mark 11.

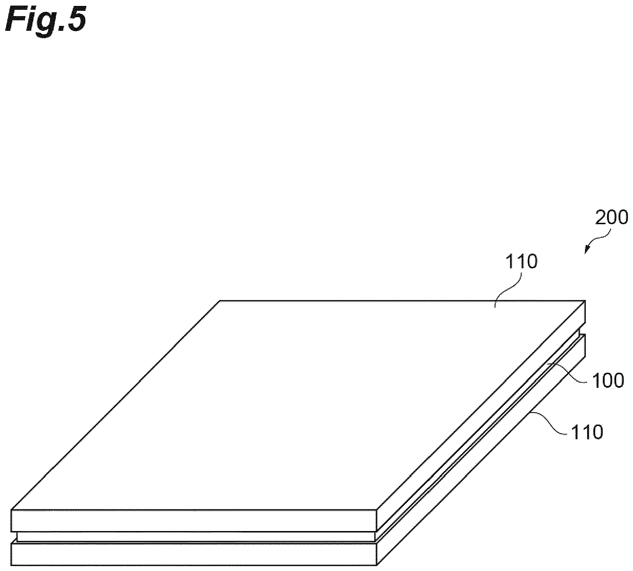

FIG. 5 is a perspective view of an intermediate composite substrate obtained during the manufacturing of a composite substrate according to an embodiment. A composite substrate 200 includes a pair of metal sheets 110 disposed so as to face each other and the ceramic substrate 100 between the pair of metal sheets 110. The pair of metal sheets 110 are joined to the ceramic substrate 100 so as to cover the main surface 100A and the main surface 100B of the ceramic substrate 100. Examples of the metal sheet 110 include a copper plate. The shapes and sizes of the ceramic substrate 100 and the metal sheet 110 may be identical to or different from each other. The metal sheet 110 and the ceramic substrate 100 may be joined by, for example, a brazing material.

The composite substrate 200 includes the ceramic substrate 100, and thus the alignment at a time of joining can be performed with ease. In addition, the composite substrate 200 includes the ceramic substrate 100 capable of enhancing the accuracy of alignment, and thus the positional accuracy of the ceramic substrate 100 and the metal sheet 110 is excellent.

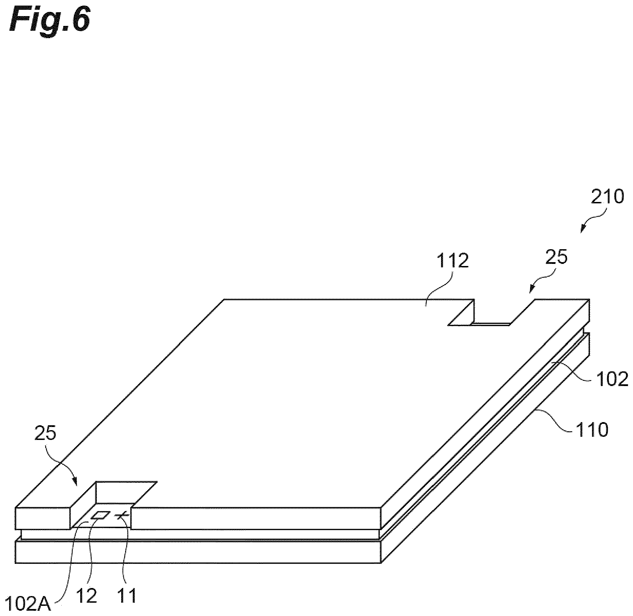

FIG 6 is a perspective view of a composite substrate according to another embodiment. A composite substrate 210 includes a metal sheet 112 and the metal sheet 110 disposed so as to face each other and the ceramic substrate 102 between the metal sheets 112 and 110. The metal sheet 112 is joined to the ceramic substrate 102 so as to cover the main surface 102A of the ceramic substrate 102. The metal sheet 110 is joined to the ceramic substrate 102 so as to cover the main surface on the side opposite to the main surface 102A. The metal sheets 112 and 110 and the ceramic substrate 102 may be joined by, for example, a brazing material.

The metal sheet 112 has two notch portions 25. The notch portion 25 is formed at a part corresponding to the position of the alignment mark 11 of the ceramic substrate 102. Accordingly, the alignment mark 11 and the identification mark 12 are exposed from one notch portion 25 and the alignment mark 11 is exposed from the other notch portion 25 (not illustrated). By having the notch portion 25 where the alignment mark 11 is exposed in this manner, the accuracy of alignment can be improved during, for example, joining between the metal sheet 112 and the ceramic substrate 102, resist application to the metal sheet 112, and circuit formation. In addition, the traceability of the composite substrate 210 can be improved by exposing the identification mark 12 from the notch portion 25.

Although only one metal sheet 112 has the notch portion 25 in the composite substrate 210, both metal sheets may be provided with the notch portion 25 in a case where the alignment mark 11 is provided on both main surfaces of the ceramic substrate. In addition, the shape, number, and positions of the notch portions 25 may be appropriately adjusted in accordance with the shape, number, and positions of the alignment marks 11. In addition, a metal sheet where the notch portion 25 is replaced with a through hole and the alignment mark 11 or the alignment mark 11 and the identification mark 12 are exposed from the through hole may be provided.

The composite substrate of the present disclosure is not limited to that described above. For example, the composite substrate of the present disclosure may include the ceramic substrate 101 instead of the ceramic substrates 100 and 102 or may include a ceramic substrate different from the ceramic substrates. In one example of the composite substrate, a ceramic substrate is made of aluminum nitride or silicon nitride and a metal sheet is made of aluminum.

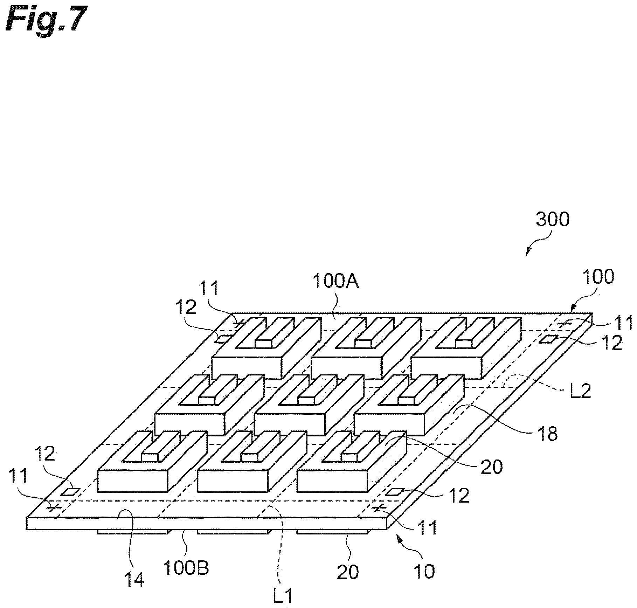

FIG 7 is a perspective view of a circuit substrate according to an embodiment. A circuit substrate 300 includes the ceramic substrate 100 and conductor portions 20 disposed so as to face each other with the ceramic substrate 100 interposed therebetween. The conductor portions 20 are independently provided on the main surface 100A and the main surface 100B for each section 18. In other words, each section 18 is provided with the pair of conductor portions 20 disposed so as to face each other. The alignment mark 11 and the identification mark 12 are exposed in the end portion 10 of the main surface 100A of the ceramic substrate 100.

The circuit substrate 300 is cut along the scribe lines L1 and L2 and divided into a plurality of divided substrates. As for the circuit substrate 300, the alignment mark 11 is exposed on the main surface 100A of the ceramic substrate 100. Accordingly, the accuracy of alignment can be improved during, for example, division. In addition, the circuit substrate 300 uses the ceramic substrate 100, the ratio of the effectively usable part of the ceramic substrate 100 to the ceramic substrate 100 is high, and thus the circuit substrate 300 and the divided substrate can be manufactured at a low manufacturing cost. The divided substrate is used as a component of, for example, a power module. An electronic component or the like is mounted on the conductor portion 20 of the divided substrate.

The circuit substrate of the present disclosure is not limited to that described above. For example, the circuit substrate of the present disclosure may include the ceramic substrate 101 or the ceramic substrate 102 instead of the ceramic substrate 100 or may include a ceramic substrate different from the ceramic substrates. In one example of the circuit substrate, a ceramic substrate is made of aluminum nitride or silicon nitride and a conductor portion is made of copper or aluminum.

A method for manufacturing the ceramic substrate 100 will be described as a ceramic substrate manufacturing method according to an embodiment. The method for manufacturing the ceramic substrate 100 has a step of obtaining a ceramic base material having an alignment mark on its main surface and a step of obtaining the ceramic substrate 100 by irradiating the main surface of the base material with laser light to form the scribe lines L1 and L2 dividing the main surface into a plurality of sections.

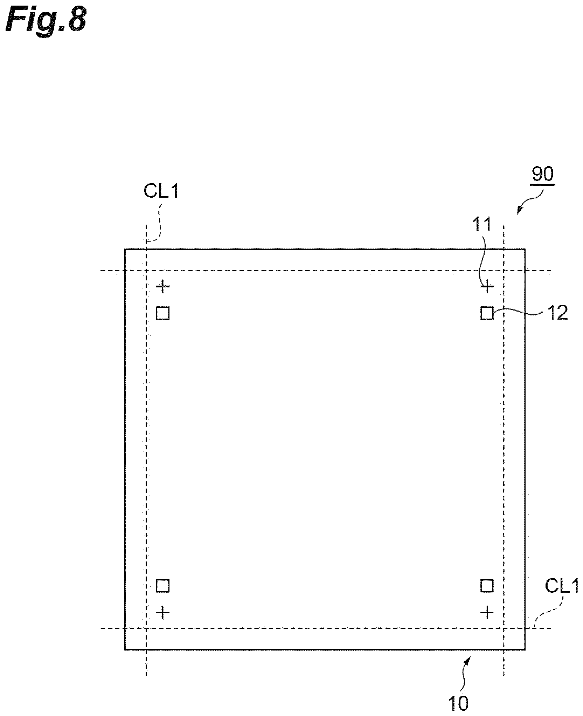

FIG 8 is a plan view illustrating an example of the ceramic base material. A ceramic base material 90 can be manufactured by the following procedure. First, a green sheet is obtained by molding slurry containing, for example, inorganic compound powder, a binder resin, a sintering aid, a plasticizer, a dispersant, and a solvent.

Examples of the inorganic compound include silicon nitride (Si₃N₄), aluminum nitride (AlN), silicon carbide, and aluminum oxide. Examples of the sintering aid include a rare earth metal, an alkaline earth metal, a metal oxide, a fluoride, a chloride, a nitrate, and a sulfate. Each of these may be used alone or two or more of these may be used in combination. By using the sintering aid, the sintering of the inorganic compound powder can be promoted. Examples of the binder resin include methyl cellulose, ethyl cellulose, polyvinyl alcohol, polyvinyl butyral, and a (meth)acrylic resin.

Examples of the plasticizer include phthalic acid-based plasticizers such as purified glycerin, glycerin triolate, diethylene glycol, and di-n-butyl phthalate and dibasic acid-based plasticizers such as di-2-ethylhexyl sebacate. Examples of the dispersant include poly(meth)acrylates and (meth)acrylic acid-maleate copolymers. Examples of the solvent include organic solvents such as ethanol and toluene.

Examples of the slurry molding method include a doctor blade method and an extrusion molding method. Recessed portions constituting alignment and identification marks are formed by irradiating the main surface of the molded green sheet with laser light. An infrared laser, a visible light laser, an ultraviolet laser, or the like may be used for the formation of the recessed portions.

Next, the ceramic base material 90 is obtained by degreasing and sintering the green sheet with the recessed portions formed on the main surface. The degreasing may be performed by, for example, performing heating for 0.5 to 20 hours at 400 to 800°C. As a result, the residual amount of the organic matter (carbon) can be reduced while suppressing the oxidation and deterioration of the inorganic compound. The sintering is performed by performing heating to 1700 to 1900°C in an atmosphere of a non-oxidizing gas such as nitrogen, argon, ammonia, and hydrogen. As a result, the base material 90 can be obtained.

With an alignment mark provided in the green sheet stage, alignment can be performed with high accuracy even in the degreasing and sintering step. In addition, with an identification mark provided together with an alignment mark, traceability can be ensured up to the green sheet stage. However, it is not essential to provide the alignment and identification marks in the green sheet stage and at least one of the marks may be provided after, for example, the base material 90 is prepared.

The degreasing and sintering described above may be performed with a plurality of green sheets laminated. Green sheets having alignment marks can be laminated with high positional accuracy. In a case where the degreasing and sintering are performed after lamination, a mold release layer using a mold release agent may be provided between the green sheets so that the base material is smoothly separated after firing. Boron nitride (BN) and so on can be used as the mold release agent. The mold release layer may be formed by, for example, applying slurry of boron nitride powder by a method such as spraying, brushing, roll coating, and screen printing. The positional accuracy of the mold release layer can also be improved by using an alignment mark here. 8 to 100 green sheets, 30 to 70 green sheets, and so on may be laminated from the viewpoint of allowing degreasing to proceed sufficiently while efficiently mass-producing ceramic substrates.

In this manner, the ceramic base material 90 having the alignment mark 11 on its main surface can be obtained. Usually, green sheets do not shrink uniformly during firing. Accordingly, the obtained base material 90 may be cut along a cutting line CL1 of FIG 8 and the outer edge portion may be cut off. In this manner, the dimensional accuracy of the ceramic substrate can be improved. Further, the dimensions of the ceramic base material can be controlled with high accuracy by performing alignment using the alignment mark 11 during the cutting. The base material 90 can be cut by laser light.

Before, after, or simultaneously with the cutting of the base material 90, one main surface of the base material 90 and, if necessary, the other main surface of the base material 90 are irradiated with laser light. Scribe lines serving as the scribe lines L1 and L2 are formed as a result. Also at this time, the positional accuracy of the scribe lines L1 and L2 can be enhanced by performing alignment using the alignment mark 11. As a result, accidentally damaging the identification mark 12 can be suppressed sufficiently. The scribe lines L1 and L2 serve as cutting lines when the circuit substrate 300 is divided in the subsequent step. Examples of a laser source for the cutting and scribe line formation include a carbonic acid gas laser and a YAG laser.

The ceramic substrate 100 as illustrated in FIGS. 1 and 2 is obtained in this manner. The ceramic substrates 101 and 102 can also be manufactured in a similar manner. The base material 90 has the alignment mark 11. Accordingly, the identification mark 12 being damaged when the scribe lines L1 and L2 are formed can be suppressed even when the end portion 10 is provided with the identification mark 12 with the end portion 10 reduced in size. In addition, even in a case where the identification mark 12 is provided after the formation of the scribe lines L1 and L2, the identification mark 12 can be provided in the narrow end portion 10 with high positional accuracy.

The ceramic substrate 100 described above is used for a composite substrate manufacturing method according to an embodiment. In other words, this manufacturing method has a step of laminating each metal sheet 110 so as to cover the main surface 100A and the main surface 100B of the ceramic substrate 100 and joining the pair of metal sheets 110 to the ceramic substrate 100 to obtain a composite substrate. The metal sheet 110 may have a flat plate shape similar to that of the ceramic substrate 100. The pair of metal sheets 110 are respectively joined to the main surface 100A and the main surface 100B of the ceramic substrate 100 via a brazing material.

Specifically, first, the paste-shaped brazing material is applied to the main surface 100A and the main surface 100B of the ceramic substrate 100 by a method such as a roll coater method, a screen printing method, and a transfer method. The brazing material contains, for example, a metal component such as silver and titanium, an organic solvent, and a binder. The viscosity of the brazing material may be, for example, 5 to 20 Pa·s. The content of the organic solvent in the brazing material may be, for example, 5 to 25% by mass. The content of the binder in the brazing material may be, for example, 2 to 15% by mass.

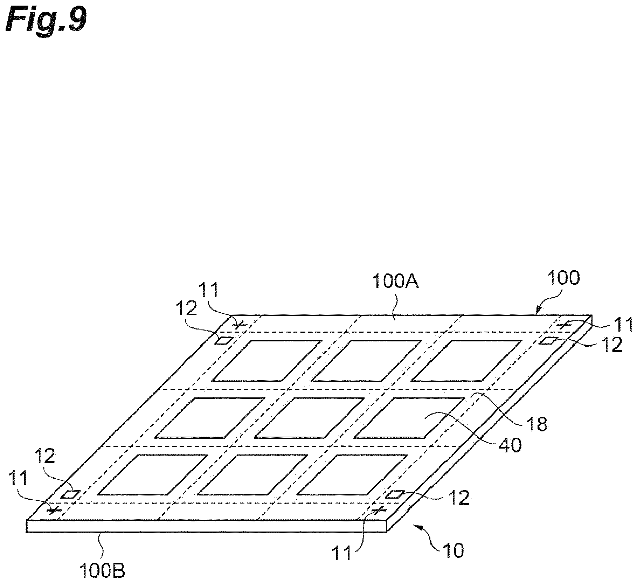

FIG 9 is a perspective view illustrating the ceramic substrate 100 to which a brazing material 40 is applied. Although only the main surface 100A side is illustrated in FIG 9, the brazing material 40 may be applied to the main surface 100B side as well. When the brazing material 40 is applied, the positional accuracy of the brazing material 40 on the main surface 100A and the main surface 100B can be enhanced by performing alignment using the alignment mark 11. Also, the positional accuracy of the ceramic substrate 100 and the metal sheet 110 on the composite substrate 200 can be enhanced by performing alignment using the alignment mark 11 when the metal sheet 110 is attached to the main surface 100A and the main surface 100B of the ceramic substrate 100.

In this manner, the metal sheet 110 is attached to the main surface 100A and the main surface 100B of the ceramic substrate 100 to which the brazing material 40 is applied. Then, the ceramic substrate 100 and the metal sheet 110 are sufficiently joined by heating in a heating furnace to obtain the composite substrate 200 illustrated in FIG 5. The heating temperature may be, for example, 700 to 900°C. The atmosphere in the furnace may be an inert gas such as nitrogen, and the process may be performed under reduced pressure below atmospheric pressure or under vacuum. The heating furnace may be a continuous furnace where a plurality of joined bodies are continuously manufactured or a furnace where one or more joined bodies are batch-manufactured. The heating may be performed while pressing a joined body in the lamination direction.

In a modification example, a metal sheet having notch portions at its four corners may be used instead of the metal sheet 110. In this manner, a composite substrate where the alignment mark 11 and the identification mark 12 are exposed from the notch portion can be obtained. In another modification example, the composite substrate 210 of FIG 6 may be obtained by joining the ceramic substrate 102 of FIG 4 so as to be sandwiched between the metal sheet 112 and the metal sheet 110.

In these manufacturing methods, a ceramic substrate having an alignment mark is used, and thus alignment can be easily performed during joining. Accordingly, the composite substrate can be manufactured at a low manufacturing cost. In addition, the alignment accuracy of the ceramic and metal sheets can be enhanced since the ceramic substrate capable of enhancing alignment accuracy is used.

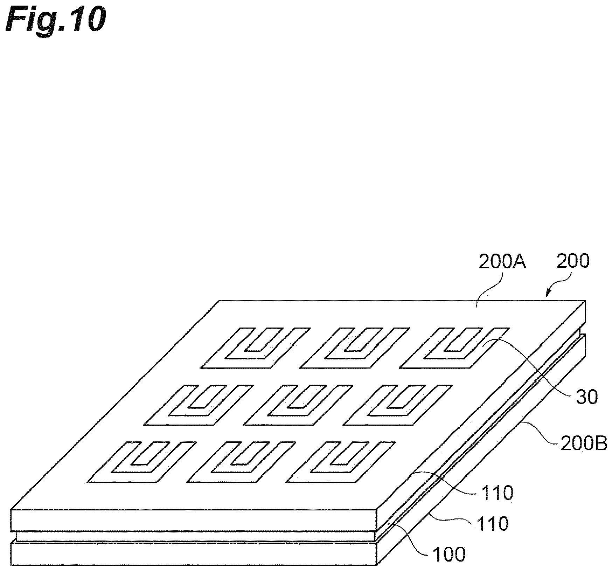

A circuit substrate manufacturing method according to an embodiment has a step of forming the independent conductor portion 20 for each section 18 by removing a part of the metal sheet 110 in the composite substrate 200 following the composite substrate manufacturing method described above. This step may be performed by, for example, photolithography. Specifically, first, a photosensitive resist is printed on a main surface 200A of the composite substrate 200 as illustrated in FIG 10. Then, a resist pattern having a predetermined shape is formed using an exposure apparatus. The resist may be a negative-type resist or a positive-type resist. The uncured resist is removed by, for example, washing.

FIG 10 is a perspective view illustrating the composite substrate 200 where resist patterns 30 are formed on the main surface 200A. Although only the main surface 200A side is illustrated in FIG 10, similar resist patterns are formed on the main surface 200B side as well. The resist patterns 30 are formed in the regions of the main surface 200A and the main surface 200B that correspond to the sections 18 of the ceramic substrate 100.

After the resist pattern 30 is formed, the part of the metal sheet 110 that is not covered with the resist pattern 30 is removed by etching. As a result, the main surface 100A and the main surface 100B of the ceramic substrate 100 are exposed at the part. At this time, the alignment mark 11 and the identification mark 12 in the end portion of the main surface 100A (100B) are exposed as illustrated in FIG 7. Subsequently, the resist pattern 30 is removed and the independent conductor portion 20 is formed for each section 18. As illustrated in FIG 7, the conductor portions 20 are formed so as to form a pair for each section 18 with the ceramic substrate 100 interposed therebetween. The circuit substrate 300 as illustrated in FIG 7 is obtained by the above steps.

In the circuit substrate 300 obtained by such a manufacturing method, the alignment mark 11 is exposed on the main surface 100A (100B) of the ceramic substrate 100. Accordingly, the alignment accuracy at a time when, for example, a divided substrate is obtained by division can be improved. In addition, the circuit substrate 300 can be manufactured at a low manufacturing cost since the ceramic substrate 100 is used.

In a modification example, the composite substrate 210 illustrated in FIG 6 may be used instead of the composite substrate 200. In the composite substrate 210, the alignment mark 11 is exposed from the notch portion 25, and thus alignment can be performed using the alignment mark 11 during the formation of the resist pattern 30 for forming the conductor portion 20 and etching as well. Accordingly, the shape accuracy of the conductor portion 20 can be sufficiently enhanced. In addition, the identification mark 12 is exposed from the notch portion 25, and thus traceability can be consistently ensured until the circuit substrate 300 is obtained from the ceramic substrate 102.

Although several embodiments of the present disclosure have been described above, the present disclosure is not limited to the embodiments described above, but only by the subject-matter of the appended claims. For example, the conductor portions 20 provided in the sections 18 do not have to have the same shape and the conductor portions 20 in the sections 18 may have different shapes. In addition, the ceramic substrate and the composite substrate may have a shape other than the shape of a quadrangular prism.

Any surface treatment may be applied to the conductor portion 20 of the circuit substrate 300. For example, a part of the surface of the conductor portion 20 may be coated with a protective layer such as a solder resist with another part of the surface of the conductor portion 20 plated.

### Industrial Applicability

According to the present disclosure, a ceramic substrate capable of enhancing alignment accuracy and a method for manufacturing the same can be provided. In addition, the present disclosure is capable of providing a composite substrate in which the positional accuracy of metal and ceramic substrates is excellent and a method for manufacturing the same. In addition, the present disclosure is capable of providing a circuit substrate excellent in alignment accuracy when a divided substrate is obtained by division and a method for manufacturing the same.

### Reference Signs List

10: end portion, 11, 11A: alignment mark, 12: identification mark, 12a: recessed portion, 14: outer edge, 18: section, 20: conductor portion, 25: notch portion, 30: resist pattern, 40: brazing material, 90: base material, 100, 101, 102: ceramic substrate, 100A, 101A, 102A, 200A: main surface (front surface), 100B, 200B: main surface (back surface), 110, 112: metal sheet, 200, 210: composite substrate, 300: circuit substrate, L1, L2, L3, L4: scribe line, C: center.

## Claims

1. A composite substrate (200, 210) comprising a ceramic substrate (100, 101, 102) and a metal sheet (110, 112), wherein
the ceramic substrate (100, 101, 102) comprises a main surface (100A, 101A, 102A) having a plurality of sections (18) divided by scribe lines (L1, L2, L3, L4) and an alignment mark (11, 11A),
wherein the main surface (100A, 101A, 102A) has at least one of the scribe lines (L1, L2, L3, L4) closer to a center (C) of the main surface (100A, 101A, 102A) than the alignment mark (11, 11A);
wherein the metal sheet (110, 112) is joined to the ceramic substrate (100, 101, 102) so as to cover the main surface (100A, 101A, 102A),
**characterized in that**
the alignment mark (11, 11A) is provided in an end portion (10) delimited by an outer edge (14) of the main surface (100A, 101A, 102A) and the scribe line (L1, L2, L3, L4) positioned farthest from the center (C) of the main surface (100A, 101A, 102A),
wherein the metal sheet (110, 112) has at least one selected from a group consisting of a notch portion (25) and a through hole, and
wherein the alignment mark (11, 11A) is exposed from the notch portion (25) or the through hole.

2. The composite substrate (200, 210) according to claim 1, wherein the alignment mark (11, 11A) has at least one selected from a group consisting of an intersection and a rotationally symmetric shape.

3. The composite substrate (200, 210) according to claim 1 or 2, wherein
an identification mark (12) different in shape from the alignment mark (11, 11A) is provided on the main surface (100A, 101A, 102A) of the ceramic substrate (100, 101, 102), and
at least one of the scribe lines (L1, L2, L3, L4) is provided closer to the center (C) of the main surface (100A, 101A, 102A) than the identification mark (12) and said identification mark (12) is provided in said end portion (10).

4. The composite substrate (200, 210) according to any one of claims 1 to 3, wherein the alignment mark (11, 11A) is two or more in number.

5. A composite substrate manufacturing method comprising:
a step of obtaining a ceramic base material (90) having an alignment mark (11, 11A) on a main surface (100A, 101A, 102A);
a step of obtaining a ceramic substrate (100, 101, 102) by irradiating the main surface (100A, 101A, 102A) with laser light to form scribe lines (L1, L2, L3, L4) dividing the main surface (100A, 101A, 102A) into a plurality of sections; and
a step of obtaining the composite substrate (200, 210) by joining a metal sheet (110, 112) to the ceramic substrate (100, 101, 102) so as to cover the main surface of the ceramic substrate (100, 101, 102),
wherein the main surface of the ceramic substrate has at least one of the scribe lines (L1, L2, L3, L4) closer to a center (C) of the main surface (100A, 101A, 102A) than the alignment mark (11, 11A),
**characterized in that**
the alignment mark (11, 11A) is provided in an end portion (10) delimited by an outer edge (14) of the main surface (100A, 101A, 102A) and the scribe line (L1, L2, L3, L4) positioned farthest from the center (C) of the main surface (100A, 101A, 102A), and
wherein the metal sheet (110, 112) is joined in the step of obtaining the composite substrate (200, 210) such that the alignment mark (11, 11A) is exposed from at least one selected from a group consisting of a notch portion (25) and a through hole of the metal sheet (110, 112).

6. A circuit substrate (300) manufacturing method comprising:
a step of obtaining a circuit substrate (300) where the alignment mark (11, 11A) on the main surface (100A, 101A, 102A) of the ceramic substrate (100, 101, 102) is exposed by removing a part of the metal sheet (110, 112) in the composite substrate (200, 210) obtained by the manufacturing method according to claim 5 and forming an independent conductor portion (20) for each section (18) defined by the scribe lines (L1, L2, L3, L4).

## Patentansprüche

1. Verbundsubstrat (200, 210), umfassend ein Keramiksubstrat (100, 101, 102) und eine Metallfolie (110, 112), wobei
das Keramiksubstrat (100, 101, 102) eine Hauptoberfläche (100A, 101A, 102A) mit einer Mehrzahl von Bereichen (18), welche durch Ritzlinien (L1, L2, L3, L4) unterteilt sind, und eine Ausrichtungsmarkierung (11, 11A) umfasst,
wobei auf der Hauptoberfläche (100A, 101A, 102A) mindestens eine der Ritzlinien (L1, L2, L3, L4) näher an einer Mitte (C) der Hauptoberfläche (100A, 101A, 102A) liegt als die Ausrichtungsmarkierung (11, 11A);
wobei die Metallfolie (110, 112) mit dem Keramiksubstrat (100, 101, 102) so verbunden ist, dass sie die Hauptoberfläche (100A, 101A, 102A) bedeckt,
**dadurch gekennzeichnet, dass**
die Ausrichtungsmarkierung (11, 11A) in einem Endabschnitt (10) vorgesehen ist, der durch eine Außenkante (14) der Hauptoberfläche (100A, 101A, 102A) und die Ritzlinie (L1, L2, L3, L4), die am weitesten von der Mitte (C) der Hauptoberfläche (100A, 101A, 102A) entfernt ist, begrenzt ist,
wobei die Metallfolie (110, 112) mindestens eines ausgewählt aus einer Gruppe bestehend aus einem Aussparungsabschnitt (25) und einem Durchgangsloch aufweist und
wobei die Ausrichtungsmarkierung (11, 11A) durch dem Aussparungsabschnitt (25) oder dem Durchgangsloch freigelegt ist.

2. Verbundsubstrat (200, 210) nach Anspruch 1, wobei die Ausrichtungsmarkierung (11, 11A) mindestens eines ausgewählt aus einer Gruppe bestehend aus einem Schnittpunkt und einer rotationssymmetrischen Form aufweist.

3. Verbundsubstrat (200, 210) nach Anspruch 1 oder 2, wobei
eine Identifikationsmarkierung (12), die sich in ihrer Form von der Ausrichtungsmarkierung (11, 11A) unterscheidet, auf der Hauptoberfläche (100A, 101A, 102A) des Keramiksubstrats (100, 101, 102) vorgesehen ist und
mindestens eine der Ritzlinien (L1, L2, L3, L4) näher an der Mitte (C) der Hauptoberfläche (100A, 101A, 102A) vorgesehen ist als die Identifikationsmarkierung (12) und die Identifikationsmarkierung (12) in dem Endabschnitt (10) vorgesehen ist.

4. Verbundsubstrat (200, 210) nach einem der Ansprüche 1 bis 3, wobei die Anzahl der Ausrichtungsmarkierungen (11, 11A) zwei oder mehr beträgt.

5. Verfahren zur Herstellung eines Verbundsubstrats, umfassend:
einen Schritt des Gewinnens eines keramischen Grundmaterials (90) mit einer Ausrichtungsmarkierung (11, 11A) auf einer Hauptoberfläche (100A, 101A, 102A);
einen Schritt des Erhaltens eines Keramiksubstrats (100, 101, 102) durch Bestrahlen der Hauptoberfläche (100A, 101A, 102A) mit Laserlicht, um Ritzlinien (L1, L2, L3, L4) auszubilden, welche die Hauptoberfläche (100A, 101A, 102A) in eine Mehrzahl von Bereichen unterteilen; und
einen Schritt des Erhaltens des Verbundsubstrats (200, 210) durch Verbinden einer Metallfolie (110, 112) mit dem Keramiksubstrat (100, 101, 102), sodass die Hauptoberfläche des Keramiksubstrats (100, 101, 102) bedeckt wird,
wobei auf der Hauptoberfläche des Keramiksubstrats mindestens eine der Ritzlinien (L1, L2, L3, L4) näher an einer Mitte (C) der Hauptoberfläche (100A, 101A, 102A) liegt als die Ausrichtungsmarkierung (11, 11A),
**dadurch gekennzeichnet, dass**
die Ausrichtungsmarkierung (11, 11A) in einem Endabschnitt (10) vorgesehen ist, der durch eine Außenkante (14) der Hauptoberfläche (100A, 101A, 102A) und die Ritzlinie (L1, L2, L3, L4), die am weitesten von der Mitte (C) der Hauptoberfläche (100A, 101A, 102A) entfernt ist, begrenzt ist, und
wobei die Metallfolie (110, 112) in dem Schritt des Erhaltens des Verbundsubstrats (200, 210) derart verbunden wird, dass die Ausrichtungsmarkierung (11, 11A) von mindestens einem ausgewählt aus einer Gruppe bestehend aus einem Aussparungsabschnitt (25) und einem Durchgangsloch der Metallfolie (110, 112) freigelegt ist.

6. Verfahren zur Herstellung eines Schaltungssubstrats (300), umfassend:
einen Schritt des Erhaltens eines Schaltungssubstrats (300), bei dem die Ausrichtungsmarkierung (11, 11A) auf der Hauptoberfläche (100A, 101A, 102A) des Keramiksubstrats (100, 101, 102) durch Entfernen eines Teils der Metallfolie (110, 112) in dem durch das Herstellungsverfahren nach Anspruch 5 gewonnenen Verbundsubstrat (200, 210) freigelegt wird, und des Ausbildens eines unabhängigen Leiterabschnitts (20) für jeden der durch die Ritzlinien (L1, L2, L3, L4) definierten Bereiche (18).

## Revendications

1. Substrat composite (200, 210) comprenant un substrat céramique (100, 101, 102) et une plaque métallique (110, 112), où
le substrat céramique (100, 101, 102) comprend une surface principale (100A, 101A, 102A) présentant une pluralité de sections (18) divisées par des lignes tracées (L1, L2, L3, L4) et une marque d'alignement (11, 11A),
où la surface principale (100A, 101A, 102A) présente au moins une des lignes tracées (L1, L2, L3, L4) plus près d'un centre (C) de la surface principale (100A, 101A, 102A) que la marque d'alignement (11, 11A) ;
où la plaque métallique (110, 112) est reliée au substrat céramique (100, 101, 102) de manière à recouvrir la surface principale (100A, 101A, 102A),
**caractérisé en ce que**
la marque d'alignement (11, 11A) est située dans une extrémité (10) délimitée par un bord extérieur (14) de la surface principale (100A, 101A, 102A) et la ligne tracée (L1, L2, L3, L4) positionnée le plus loin possible du centre (C) de la surface principale (100A, 101A, 102A),
où la plaque métallique (110, 112) présente au moins un élément choisi dans un groupe constitué d'une encoche (25) et d'un trou traversant, et
où la marque d'alignement (11, 11A) est exposée à partir de l'encoche (25) ou du trou traversant.

2. Substrat composite (200, 210) selon la revendication 1, où la marque d'alignement (11, 11A) présente au moins un élément choisi dans un groupe constitué d'une intersection et d'une forme à symétrie de rotation.

3. Substrat composite (200, 210) selon la revendication 1 ou 2, où
une marque d'identification (12) de forme différente de la marque d'alignement (11, 11A) est située sur la surface principale (100A, 101A, 102A) du substrat céramique (100, 101, 102), et
au moins une des lignes tracées (L1, L2, L3, L4) est située plus près du centre (C) de la surface principale (100A, 101A, 102A) que la marque d'identification (12), et
ladite marque d'identification (12) est située dans ladite extrémité (10).

4. Substrat composite (200, 210) selon l'une quelconque des revendications 1 à 3, où la marque d'alignement (11, 11A) est au nombre de deux ou plus.

5. Procédé de fabrication d'un substrat composite comprenant :
une étape consistant à obtenir un matériau à base de céramique (90) présentant une marque d'alignement (11, 11A) sur une surface principale (100A, 101A, 102A) ;
une étape consistant à obtenir un substrat céramique (100, 101, 102) en irradiant la surface principale (100A, 101A, 102A) avec une lumière laser pour former des lignes tracées (L1, L2, L3, L4) divisant la surface principale (100A, 101A, 102A) en une pluralité de sections ; et
une étape consistant à obtenir le substrat composite (200, 210) en assemblant une plaque métallique (110, 112) au substrat céramique (100, 101, 102) de manière à recouvrir la surface principale du substrat céramique (100, 101, 102),
où la surface principale du substrat céramique présente au moins une des lignes tracées (L1, L2, L3, L4) plus près d'un centre (C) de la surface principale (100A, 101A, 102A) que la marque d'alignement (11, 11A),
**caractérisé en ce que**
la marque d'alignement (11, 11A) est située dans une extrémité (10) délimitée par un bord extérieur (14) de la surface principale (100A, 101A, 102A) et la ligne tracée (L1, L2, L3, L4) positionnée le plus loin possible du centre (C) de la surface principale (100A, 101A, 102A), et
où la plaque métallique (110, 112) est assemblée lors de l'étape consistant à obtenir le substrat composite (200, 210) de manière à ce que la marque d'alignement (11, 11A) soit exposée à partir d'au moins un élément choisi dans un groupe constitué d'une encoche (25) et d'un trou traversant de la plaque métallique (110, 112).

6. Procédé de fabrication d'un substrat de circuit (300) comprenant :
une étape consistant à obtenir un substrat de circuit (300) où la marque d'alignement (11, 11A) sur la surface principale (100A, 101A, 102A) du substrat céramique (100, 101, 102) est exposée en enlevant une partie de la plaque métallique (110, 112) dans le substrat composite (200, 210) obtenu par le procédé de fabrication selon la revendication 5 et formant une partie conductrice indépendante (20) pour chaque section (18) définie par les lignes tracées (L1, L2, L3, L4).
